# EUROPEAN PATENT APPLICATION

(11) **EP 4 525 133 A1**
(43) Date of publication of application: **19.03.2025**
(21) Application number: 23907566.6
(22) Date of filing: 13.12.2023
(51) Int. Cl.: H01M 10/42, H01M 50/284, H01M 50/298, H01M 50/211, H01M 50/209, H01M 50/213

(54) **BATTERY SYSTEM AND FLEXIBLE PRINTED CIRCUIT BOARD**

(30) Priority: 23.12.2022 KR 20220183599; 07.12.2023 KR 20230176480
(71) Applicant: LG Energy Solution, Ltd., Seoul 07335 (KR)
(72) Inventor: CHOI, Jongtae, Daejeon 34122 (KR)
(74) Representative: Plasseraud IP
(86) International application number: PCT/KR2023/020546
(87) International publication number: WO 2024/136280

(57) **Abstract**

A battery system may include a battery pack including a plurality of battery cells, a flexible printed circuit board (FPCB) located on an upper surface of the battery pack and including a first wiring connected to a terminal of the battery pack and a second wiring arranged along a path passing through upper portions of each of the plurality of battery cells, and a battery management system (BMS) including a logic gate that is driven by a first voltage provided from the battery pack through the first wiring and generates an output according to a second voltage provided through the second wiring. Further, the BMS may be configured to determine whether the battery pack is abnormal according to the output of the logic gate.

## Description

### [Technical Field]

### CROSS-REFERENCE TO RELATED APPLICATION

This application claims priority to and the benefit of Korean Patent Application Nos. 10-2022-0183599 and 10-2023-0176480 filed in the Korean Intellectual Property Office on December 23, 2022 and December 7, 2023, the entire contents of which are incorporated herein by reference.

Th present disclosure relates to a battery system and a flexible circuit board.

### [Background Art]

With the spread of electric vehicles, a fire is often occurring in the electric vehicles. A fire occurring in electric vehicles is mainly due to characteristics of lithium-ion batteries used as batteries of the electric vehicle. When a fire occurs, a spread rate of fire is fast, and it may take a very long time and effort to extinguish the fire.

When a fire occurs in batteries of electric vehicles, technologies of detecting a fire at an early stage is necessary because detecting the fire at an early stage may encourage passengers in the electric vehicles to escape and ensure safety. However, in order to detect a fire, a battery system should operate all the time or periodically, which has the problem of discharging batteries in normal use environments.

### [Disclosure]

### [Technical Problem]

The present disclosure attempts to provide a battery system that detects a fire occurring in a battery at an early stage, and a flexible circuit board.

### [Technical Solution]

According to an aspect of the present disclosure, a battery system includes: battery packs including a plurality of battery cells; a flexible printed circuit board (FPCB) located on an upper surface of the plurality of packs and including a first wiring connected to a terminal of the battery pack and a second wiring arranged along a path passing through upper portions of each of the plurality of battery cells; and a battery management system (BMS) including a logic gate that is driven by a first voltage provided from the battery pack through the first wiring and generates an output according to a second voltage provided through the second wiring, in which the BMS may determine whether the battery pack is abnormal according to the output of the logic gate.

When each of the plurality of battery cells is a pouch-type battery, the second wiring may be arranged in a rectangular pattern passing through the upper portions of each of the plurality of battery cells.

When each of the plurality of battery cells is a cylindrical battery, a wire may be connected to an upper end of the cylindrical battery, and the second wiring may bypass the wire and may be arranged in a round pattern passing through the upper portions of each of the plurality of battery cells.

When each of the plurality of battery cells is a prismatic battery, the prismatic battery may include a pressure vent, and the second wiring may be arranged in a rectangular pattern passing through an area corresponding to the pressure vent among the plurality of battery cells.

The logic gate may be a NOT-AND (NAND) gate that uses the first voltage and the second voltage as inputs.

The logic gate may be a NOT gate that uses the second voltage as an input.

The second wiring may include a third wiring and a fourth wiring arranged along the path passing through the upper portions of each of the plurality of battery cells, and the logic gate may be a NAND gate that uses a third voltage detected through the third wiring and a fourth voltage detected through the fourth wiring as inputs.

The BMS may perform a protection operation when the logic gate outputs a high level signal.

The BMS may further include a NOT gate that uses the output of the logic gate as an input and invert the output of the logic gate, and the BMS may perform a protection operation when the NOT gate outputs a low level signal.

According to another aspect of the present invention, a flexible printed circuit board electrically connecting a battery management system (BMS) and a battery pack including a plurality of battery cells includes: a connector including a first terminal connected to a first input terminal of the BMS and a second terminal connected to a second input terminal of the BMS; a first wiring connected between a positive electrode of the battery pack and the first terminal of the connector; and a second wiring having one end connected to the first wiring at a first node and another end connected to the second terminal of the connector, and arranged along a path passing through upper portions of each of the plurality of battery cells between the one end and the other end, in which the BMS may determine whether the battery pack is abnormal using a voltage of each of the first and second input terminals.

When each of the plurality of battery cells is a pouch-type battery, the second wiring may be arranged in a rectangular pattern passing through the upper portions of each of the plurality of battery cells.

When each of the plurality of battery cells is a cylindrical battery, a wire may be connected to an upper end of the cylindrical battery, and the second wiring may bypass the wire and may be arranged in a round pattern passing through the upper portions of each of the plurality of battery cells.

When each of the plurality of battery cells is a prismatic battery, the prismatic battery may include a pressure vent, and the second wiring may be arranged in a rectangular pattern passing through an area corresponding to the pressure vent among the plurality of battery cells.

### [Advantageous Effects]

According to the present disclosure, it is possible to quickly determine whether thermal runaway has occurred in a battery pack even in a low power state through a wiring pattern according to a shape of a battery cell.

According to the present disclosure, since a BMS uses a logic gate without a separate configuration such as a memory device, it is possible for the BMS to detect thermal runaway without additional operation while maintaining standby power at low power even in a vehicle in a starting OFF state.

According to the present disclosure, it is possible to quickly and simply detect thermal runaway in a battery pack to ensure safety of passengers in an electric vehicle using a battery.

According to the present disclosure, since constant operations of electronic control devices (e.g., ECU, BMS, etc.) required for fire detection are not required, it is possible to prevent unnecessary discharge under a normal state.

### [Description of the Drawings]

FIG. 1 is a block diagram schematically illustrating a battery system according to an embodiment.
FIG. 2 is a detailed configuration diagram of a flexible printed circuit board (FPCB) in FIG. 1.
FIG. 3 is a diagram of a pouch-type battery.
FIG. 4 is a diagram for describing a wiring pattern when the FPCB in FIG. 2 is located on an upper surface of the pouch-type battery.
FIG. 5 is a diagram of a cylindrical battery.
FIG. 6 is a cross-sectional view of the cylindrical battery.
FIG. 7 is a diagram for describing a wiring pattern when the FPCB in FIG. 2 is located on the upper surface of the cylindrical battery.
FIG. 8 is a diagram of a prismatic battery.
FIG. 9 is a cross-sectional view of the prismatic battery.
FIG. 10 is a diagram for describing a wiring pattern when the FPCB in FIG. 2 is located on an upper surface of the prismatic battery.
FIG. 11 is a diagram for describing a battery management system (BMS) including a NAND gate.
FIG. 12 is a diagram for describing the BMS including a NOT gate.
FIG. 13 is a diagram for describing the BMS including the NAND gate.
FIG. 14 is a diagram for describing the BMS further including the NOT gate at an output unit of the NAND gate in FIG. 11.
FIG. 15 is a diagram for describing the BMS further including the NOT gate at an output unit of the NOT gate in FIG. 12.
FIG. 16 is a diagram for describing the BMS further including the NOT gate at the output unit of the NAND gate in FIG. 13.

### [Mode for Invention]

Hereafter, embodiments of the present disclosure will be described in detail with reference to the accompanying drawings and the same or similar components are given the same reference numerals and are not repeatedly described. The suffix "module" and/or "unit" for components used in the following description is given or mixed in consideration of only the ease of writing of the specification, and therefore, do not have meanings or roles that distinguish from each other in themselves. Further, when it is decided that a detailed description for the known art related to the present disclosure may obscure the gist of the present disclosure, the detailed description will be omitted. Further, it should be understood that the accompanying drawings are provided only in order to allow embodiments of the present disclosure to be easily understood, and the spirit of the present disclosure is not limited by the accompanying drawings, but includes all the modifications, equivalents, and substitutions included in the spirit and the scope of the present disclosure.

Terms including an ordinal number such as first, second, etc., may be used to describe various components, but the components are not limited to these terms. The above terms are used solely for the purpose of distinguishing one component from another.

It will be further understood that terms "include" or "have" used in the present specification specify the presence of features, numerals, steps, operations, components, parts mentioned in the present specification, or combinations thereof, but do not preclude the presence or addition of one or more other features, numerals, steps, operations, components, parts, or combinations thereof.

Among the components according to an embodiment, a program implemented as a set of instructions specifying a control algorithm necessary for controlling other components may be installed in a component that controls other components under specific control conditions. The control component may process input data and stored data according to installed programs to generate output data. The control component may include non-volatile memory for storing programs and memory for storing data.

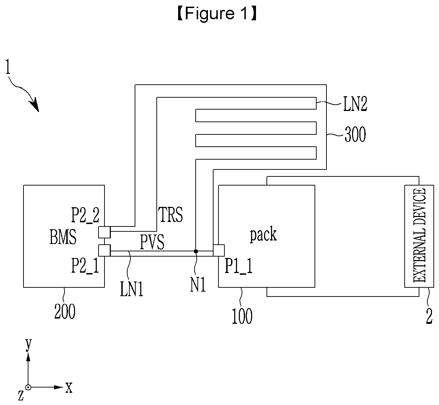

FIG. 1 is a block diagram schematically illustrating a battery system according to an embodiment.

A battery system 1 may include a battery pack 100, a battery management system (BMS) 200, and a flexible printed circuit board (FPCB) 300.

The battery pack 100 may include a plurality of battery cells. The battery pack 100 may be implemented as two or more battery cells connected in series, a plurality of battery cells having two or more battery cells connected in parallel, or two or more battery cells connected in parallel.

The FPCB 300 may include a first wiring LN1 and a second wiring LN2. The BMS 200 may determine whether the battery pack 100 is abnormal based on signals input through the first wiring LN1 and the second wiring LN2 input through the FPCB 300. For example, an abnormal state of the battery pack 100 may include thermal runaway of the battery pack 100. Hereinafter, in the present disclosure, the abnormal state of the battery pack will be described as a state in which the thermal runaway occurs in the battery pack. When the thermal runaway occurs in the battery pack 100, the second wiring LN2 may be open. The BMS 200 may determine that the thermal runaway occurs in the battery pack 100 based on an output signal of the logic gate.

The battery pack 100 may include a terminal P1_1, and the BMS 200 may include terminals P2_1 and P2_2.

The FPCB 300 may be located on an upper surface of the battery pack 100. Hereinafter, an upper portion of the battery pack 100 may represent a y-axis direction of the battery pack 100. The first wiring LN1 may be connected between the battery pack 100 and the BMS 200. The terminal P1_1 may be connected to the terminal P2_1 through the first wiring LN1. The second wiring LN2 is located at the upper portion of the battery pack 100 and may be arranged along a path passing through upper portions of each of the plurality of battery cells included in the battery pack 100. One end of the second wiring LN2 may be connected to a node N1 on the first wiring LN1. The other end of the second wiring LN2 may be connected to the terminal P2_2. The second wiring LN2 may include one or more wirings. The terminal P1_1 of the battery pack 100 may be a terminal that measures the highest cell voltage among cell voltages of each of the plurality of battery cells.

A pack voltage signal PVS may indicate a voltage detected through the first wiring LN1, and a thermal runaway detection signal TRS may indicate a voltage detected through the second wiring LN2.

The BMS 200 may receive the pack voltage signal PVS from the battery pack 100 through the first wiring LN1. The pack voltage signal PVS may include a signal indicating the voltage of the terminal P1_1. The BMS 200 may derive a pack voltage of the battery pack 100 from the pack voltage signal PVS. However, the BMS 200 may detect the thermal runaway through at least one logic gate while maintaining standby power at low power even at a state in which a power supply is turned off. At least one logic gate may include at least one of the pack voltage signal PVS and the thermal runaway detection signal TRS as an input. A level of the output of the at least one logic gate may vary as levels (e.g., high or low level) of each of the pack voltage signal PVS and the thermal runaway detection signal TRS vary.

The BMS 200 may receive the thermal runaway detection signal TRS through the second wiring LN2. The thermal runaway detection signal TRS may indicate the voltage passing through the upper portions of each of the plurality of battery cells included in the battery pack 100 from a voltage of the node N1. The BMS 200 may derive the voltage passing through the upper portions of each of the plurality of battery cells included in the battery pack 100 (hereinafter, "cell upper voltage") from the thermal runaway detection signal TRS.

The BMS 200 may determine whether the battery pack 100 is abnormal based on the output of the logic gate. Here, the logic gate is driven by the pack voltage signal PVS and may generate an output according to the thermal runaway detection signal TRS. For example, when the logic gate outputs a high level signal, the BMS 200 may determine that the thermal runaway occurs in the battery pack 100.

The battery system 1 may be connected to the external device 2. The external device 2 may include a load and a charging device such as an inverter or a converter. When the external device 2 is a charger, both terminals of the battery system 1 may connected to the charger and charged by receiving power from the charger. When the external device 2 is a load, both terminals P+ and P- of the battery system 1 are connected to the load so that the power supplied by the battery pack 10 may be discharged through the load.

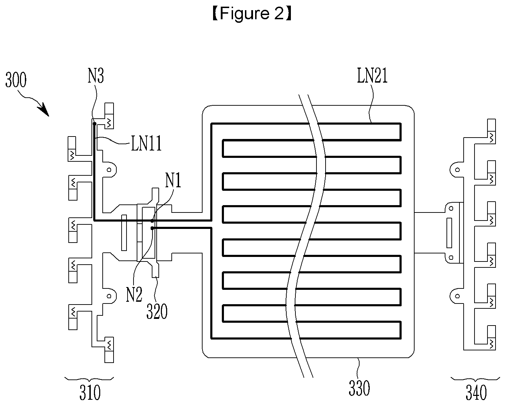

FIG. 2 is a detailed configuration diagram of the flexible printed circuit board (FPCB) in FIG. 1.

The FPCB 300 may be located on the upper surface of the battery pack 100 in FIG. 1. A first wiring LN11 in FIG. 2 is an example of the first wiring LN1 in FIG. 1, and a second wiring LN21 is an example of the second wiring LN2.

The FPCB 300 may include a first connection part 310, a connector 320, a plate 330, and a second connection part 340. The first connection part 310 may include the first wiring LN11.

The first connection part 310 may be connected to one of both ends of the battery pack 100. The plate 330 may include the second wiring LN21 arranged along the path passing through the upper portions of each of the plurality of battery cells included in the battery pack 100 in FIG. 1. A pattern of the second wiring LN21 may be determined according to a shape of the battery cell included in the battery pack 100.

The connector 320 may connect the first wiring LN11 and the second wiring LN21 to the BMS 200. The connector 320 may include a terminal connected to a terminal P2_1 of the BMS 200 in FIG. 1 and a terminal connected to a terminal P2_2 of the BMS 200 in FIG. 1. Hereinafter, for convenience of description, a node connected to the terminal connected to the terminal P2_1 of the BMS 200 in FIG. 1 is referred to as a first node N1, and the node connected to the terminal P2_2 of the BMS 200 in FIG. 1 is referred to as a second node N2. The first connection part 310 may include a third node N3. The third node N3 may be a node connected to the terminal P1_1 of the battery pack 100 in FIG. 1.

The first wiring LN11 may be connected between the first node N1 and the third node N3. One end of the first wiring LN11 may be connected to the first node and connected to the terminal P2_1 of the BMS 200 through the connector 320, and the other end of the first wiring LN11 may be connected to the third node N3 and connected to the terminal P1_1 of the battery pack 100 through the connector 320.

The second wiring LN21 may be arranged along the path passing through the upper portions of each of the plurality of battery cells included in the battery pack 100 in FIG. 1 between the first node N1 and the second node N2. One end of the second wiring LN21 may be connected to the first node N1, and the other end of the second wiring LN21 may be connected to the second node N2 and connected to the terminal P2_2 of the BMS 200 through the connector 320.

The second connection part 340 may be connected to the other end of both ends of the battery pack 100.

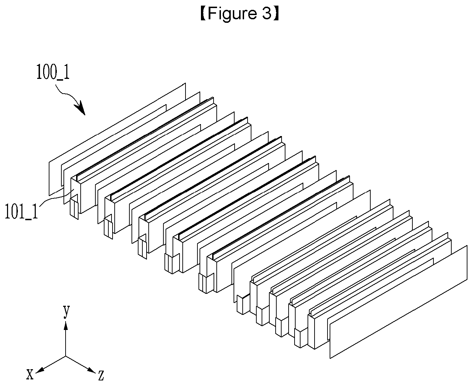

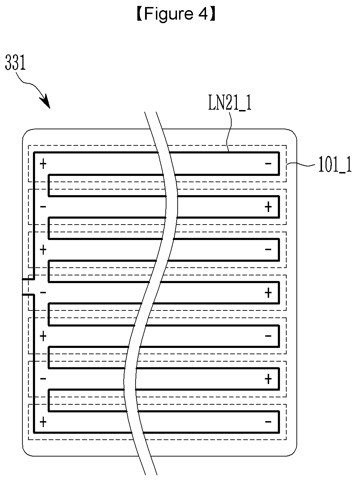

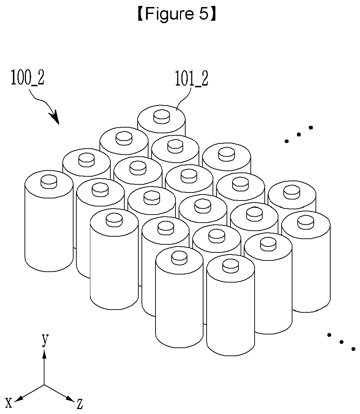

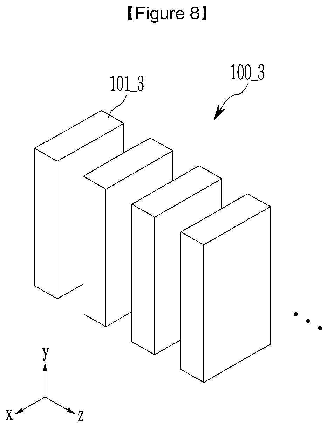

Each of the plurality of battery cells included in the battery pack 100 may be a pouch-type battery, a cylindrical battery, or a prismatic battery. Hereinafter, referring to FIGS. 3 and 4, a case where each of the plurality of battery cells included in the battery pack 100 is the pouch-type battery will be described. In addition, referring to FIGS. 5 to 7, a case where each of the plurality of battery cells included in the battery pack 100 is the cylindrical battery will be described. In addition, referring to FIGS. 8 to 10, a case where each of the plurality of battery cells included in the battery pack 100 is the prismatic battery will be described.

FIG. 3 is a diagram of the pouch-type battery.

A battery pack 100_1 in FIG. 3 is an example of the battery pack 100 in FIG. 1. The battery pack 100_1 may include a plurality of pouch-type battery cells (e.g., 101_1). Hereinafter, an upper portion of the pouch-type battery cell 101_1 represents a y-axis direction of the pouch-type battery cell 101_1.

In the pouch-type battery cell 101_1, a circumference of the battery may be sealed. When the thermal runaway occurs in the pouch-type battery cell 101_1, it is difficult to predict at what point flame will be released. Accordingly, a wiring pattern of the FPCB 300 located on the upper portion of the battery pack 100_1 may pass through all of the plurality of pouch-type battery cells.

FIG. 4 is a diagram for describing a wiring pattern when the FPCB in FIG. 2 is located on an upper surface of the pouch-type battery.

A plate 331 in FIG. 4 is an example of the plate 330 in FIG. 2. The FPCB 300 including the plate 331 may be located on an upper surface of battery pack 100_1 in FIG. 3. The plate 331 may include a second wiring LN21_1. A second wiring LN21_1 in FIG. 4 is an example of the second wiring LN21 in FIG. 2. The second wiring LN21_1 may be implemented in a pattern that passes through upper portions of each of the plurality of pouch-type battery cells (hereinafter, "pouch-type cell") included in the battery pack 100_1.

In FIG. 4, the upper portion of the pouch-type cell is illustrated as a dotted line. The upper portion of the pouch-type cell may be rectangular. The second wiring LN21_1 may be arranged in a rectangular pattern so as to pass through the entire of the pouch-type cell. That is, the FPCB located on the upper surface of the battery pack including the pouch-type battery may include a rectangular wiring pattern.

FIG. 5 is a diagram of the cylindrical battery.

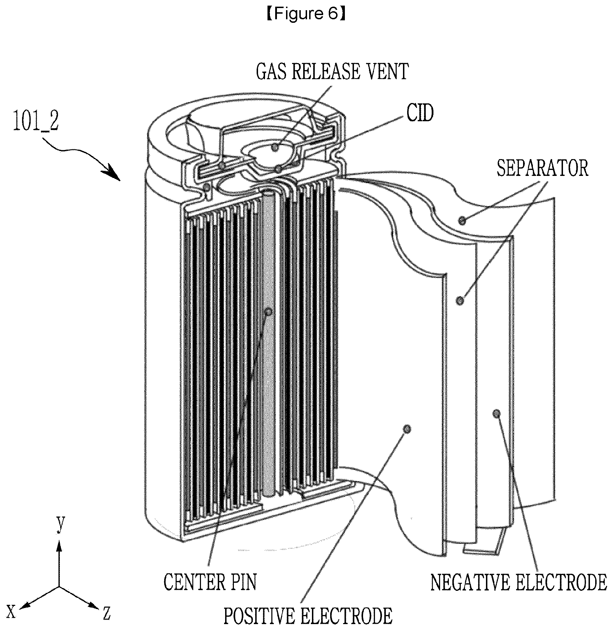

FIG. 6 is a cross-sectional view of the cylindrical battery.

A battery pack 100_2 in FIG. 5 is an example of the battery pack 100 in FIG. 1. The battery pack 100_2 may include a plurality of cylindrical battery cells (e.g., 101_2). Hereinafter, an upper portion of the cylindrical battery cell 101_2 represents a y-axis direction of the cylindrical battery cell 101_2.

Referring to FIG. 6, the cylindrical battery cell 101_2 may include a gas release vent, a current interruption device (CID), a separator, a positive electrode, a negative electrode, and a center pin, etc. The gas release vent is located in an upper middle portion of the cylindrical battery cell 101_2 and may release gas inside the cylindrical battery cell 101_2. When the thermal runaway occurs in the cylindrical battery cell 101_2, flame may be released from the gas release vent.

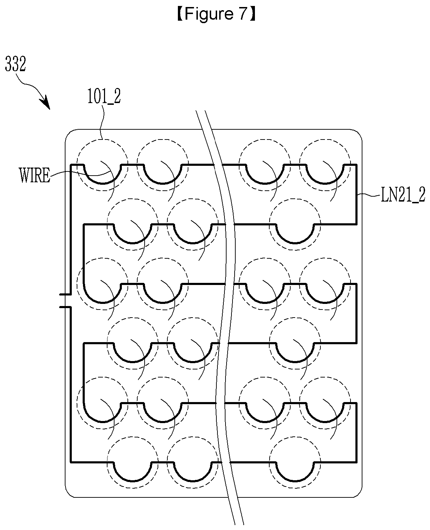

FIG. 7 is a diagram for describing a wiring pattern when the FPCB in FIG. 2 is located on the upper surface of the cylindrical battery.

A plate 332 in FIG. 7 is an example of the plate 330 in FIG. 2. The FPCB 300 including the plate 332 may be located on an upper surface of battery pack 100_2 in FIG. 5. The plate 332 may include a second wiring LN21_2. The second wiring LN21_2 in FIG. 7 is an example of the second wiring LN21 in FIG. 2. The second wiring LN21_2 may be implemented in a pattern that passes through upper portions of each of the plurality of cylindrical battery cells (hereinafter, "cylindrical cell") included in the battery pack 100_2. Since there is the gas release vent at an upper end of the battery cell 101_2, the second wiring LN21_2 may pass through locations corresponding to the plurality of gas release vents of the plurality of cylindrical battery cells.

In FIG. 7, an upper portion of the cylindrical cell is illustrated as a dotted line. The upper portion of the cylindrical cell may be circular. A wire may be connected to the upper portion of the cylindrical cell. The second wiring LN21_2 may be arranged in a round pattern so as to bypass the wire while passing through the entire upper portion of the cylindrical cell. That is, the FPCB located on the upper surface of the battery pack including the cylindrical battery may include a round wiring pattern.

FIG. 8 is a diagram of the prismatic battery.

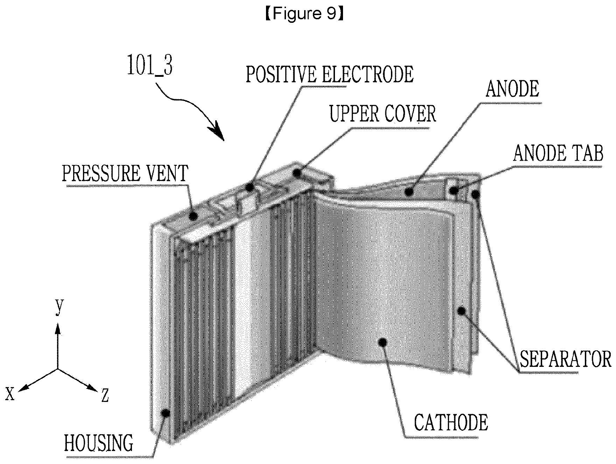

FIG. 9 is a cross-sectional view of the prismatic battery.

A battery pack 100_3 in FIG. 8 is an example of the battery pack 100 in FIG. 1. The battery pack 100_3 may include a plurality of prismatic battery cells (e.g., 101_3). Hereinafter, an upper portion of the prismatic battery cell 101_3 represents a y-axis direction of the prismatic battery cell 101_3.

Referring to FIG. 9, the prismatic battery cell 101_3 may include a pressure vent, a positive terminal, a top plate, an anode, a cathode, a separator, an anode tab, a housing (Can case), etc. The pressure vent is located on an upper surface of the prismatic battery cell 101_3 and may release pressure inside the prismatic battery cell 101_3. When the thermal runaway occurs in the prismatic battery cell 101_3, flame may be released from the pressure vent.

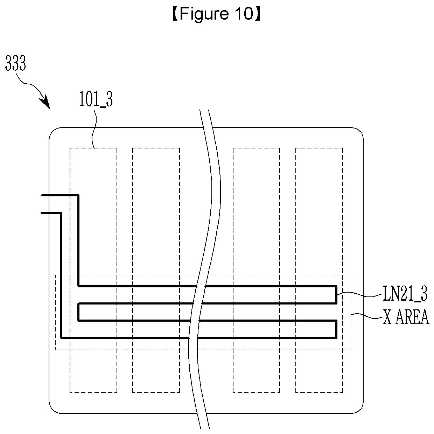

FIG. 10 is a diagram for describing a wiring pattern when the FPCB in FIG. 2 is located on an upper surface of the prismatic battery.

A plate 333 in FIG. 10 is an example of the plate 330 in FIG. 2. The FPCB 300 including the plate 333 may be located on the upper surface of battery pack 100_3 in FIGS. 8 and 9. The plate 333 may include a second wiring LN21_3. The second wiring LN21_3 in FIG. 10 is an example of the second wiring LN21 in FIG. 2. The second wiring LN21_3 may be implemented in a pattern that passes through upper portions of each of the plurality of prismatic battery cells (hereinafter, "prismatic cell") included in the battery pack 100_3.

Since there is the pressure vent at an upper end of the battery cell 101_3, the second wiring LN21_3 may pass through locations corresponding to the plurality of pressure vents of the plurality of prismatic battery cells. In FIG. 10, an area X in which the upper portion of the prismatic cell corresponds to the location of the pressure vent of the prismatic cell is illustrated as a dotted line. The upper portion of the prismatic cell may be rectangular. The upper portion of the prismatic cell may include the area X corresponding to the location of the pressure vent of the prismatic cell. The second wiring LN21_3 may be arranged in a rectangular pattern so as to pass through the area X. That is, the FPCB substrate located on the upper surface of the battery pack including the prismatic battery may include a rectangular wiring pattern.

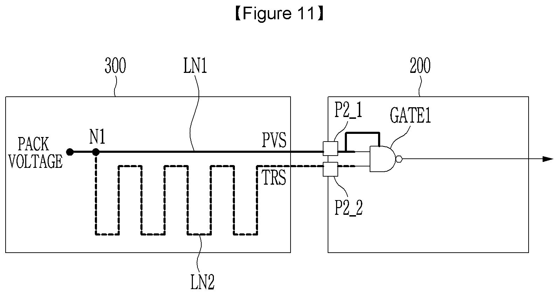

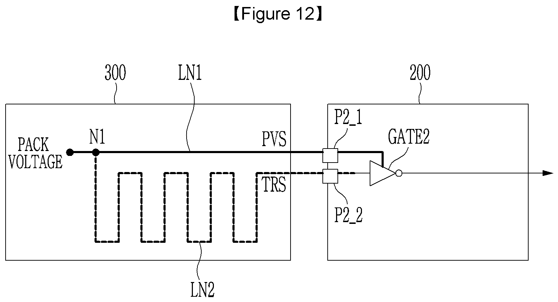

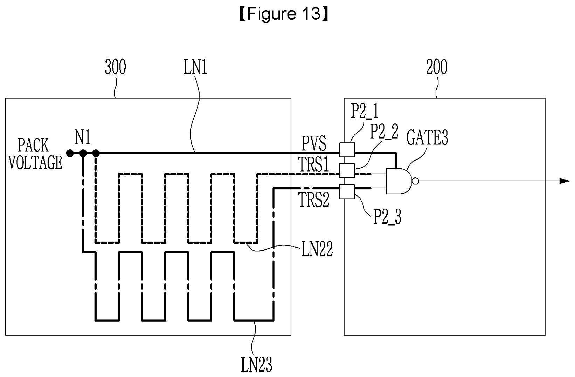

The BMS 200 may include a logic gate to determine whether the thermal runaway occurs in the battery pack 100. The logic gate may use at least one of the pack voltage signal PVS and the thermal runaway detection signal TRS as an input. The logic gate may be a NAND gate of FIGS. 11 and 13 or a NOT gate in FIG. 12. Hereinafter, an operation of the BMS 200 to determine whether the thermal runaway occurs will be described with reference to FIGS. 11 to 13.

FIG. 11 is a diagram for describing the BMS including the NAND gate.

The terminal P2_1 may receive the pack voltage signal PVS from the battery pack 100 through the first wiring LN1. The terminal P2_2 may receive the thermal runaway detection signal TRS that passes through the upper portions of each of the plurality of battery cells included in the battery pack 100 through the second wiring LN2. The BMS 200 may include a NAND gate GATE1. The NAND gate GATE1 may use the pack voltage signal PVS and the thermal runaway detection signal TRS as inputs. The pack voltage signal PVS may also be input as a power signal of the NAND gate GATE1. Accordingly, the NAND gate GATE1 may operate when the pack voltage signal PVS is a high level signal.

When the pack voltage signal PVS and the thermal runaway detection signal TRS become a high level, the NAND gate GATE1 outputs a low level signal. When the pack voltage signal PVS becomes the high level and the thermal runaway detection signal TRS becomes a low level, the NAND gate GATE1 outputs a high level signal.

The BMS 200 may measure a pack voltage of the battery pack 100 through the high-level pack voltage signal PVS. However, the BMS 200 may detect the thermal runaway through the NAND gate GATE1 while maintaining standby power at low power even in a state in which a power supply is turned off.

The BMS 200 may detect whether the thermal runaway occurs in the battery pack 100 based on the output of the NAND gate GATE1. When the thermal runaway occurs in the battery pack 100, the second wiring LN2 may be open-circuited, and when the second wiring LN2 is open-circuited, the thermal runaway detection signal TRS may become the low level. When the thermal runaway detection signal TRS becomes the low level, the NAND gate GATE1 outputs the high level signal. The BMS 200 may determine that the thermal runaway occurs in the battery pack 100 based on an output signal of the high-level of the NAND gate GATE1.

FIG. 12 is a diagram for describing the BMS including the NOT gate.

The terminal P2_1 may receive the pack voltage signal PVS from the battery pack 100 through the first wiring LN1. The terminal P2_2 may receive the thermal runaway detection signal TRS that passes through the upper portions of each of the plurality of battery cells included in the battery pack 100 through the second wiring LN2. The BMS 200 may include a NOT gate GATE2. The NOT gate GATE2 may use the thermal runaway detection signal TRS as an input. The pack voltage signal PVS may be input as a power signal of the NOT gate GATE2. Accordingly, the NOT gate GATE2 may operate when the pack voltage signal PVS is the high level signal.

When the pack voltage signal PVS and the thermal runaway detection signal TRS become a high level, the NOT gate GATE2 outputs a low level signal. When the pack voltage signal PVS becomes the high level and the thermal runaway detection signal TRS becomes a low level, the NOT gate GATE2 outputs the high level signal.

The BMS 200 may measure the pack voltage of the battery pack 100 through the high-level pack voltage signal PVS. However, the BMS 200 may detect the thermal runaway through the NOT gate GATE2 while maintaining standby power at low power even in a state in which a power supply is turned off.

The BMS 200 may detect whether the thermal runaway occurs in the battery pack 100 based on the output of the NOT gate GATE2. When the thermal runaway occurs in the battery pack 100, the second wiring LN2 may be open-circuited, and when the second wiring LN2 is open-circuited, the thermal runaway detection signal TRS may become the low level. When the thermal runaway detection signal TRS becomes the low level, the NOT gate GATE2 outputs the high level signal. The BMS 200 may determine that the thermal runaway occurs in the battery pack 100 based on an output signal of the high-level of the NOT gate GATE2.

FIG. 13 is a diagram for describing the BMS including the NAND gate.

Referring to FIG. 13, the FPCB 300 in FIG. 1 may include a wiring LN22 and a wiring LN23. The wirings LN22 and LN23 may be arranged along the path passing through the upper portions of each of the plurality of battery cells included in the battery pack 100. The wiring LN22 and LN23 may be included in the second wiring LN2 in FIG. 1. The BMS 200 may include terminals P2_1 to P2_3. For example, the wiring LN22 is connected to a path passing through upper portions of each of m battery cells (m is a natural number greater than or equal to 1 and less than n) among n battery cells (n is a natural number greater than or equal to 1) included in the battery pack 100. The wiring LN23 may be arranged along a path passing through the upper portions of each of n-m battery cells except for the m battery cells among the n battery cells. One end of each of the wirings LN22 and LN23 may be connected to the node N1 on the first wiring LN1. The other end of the wiring LN22 may be connected to the terminal P2_2. The other end of the wiring LN23 may be connected to the terminal P2_3.

The terminal P2_1 may receive the pack voltage signal PVS from the battery pack 100 through the first wiring LN1. The terminal P2_2 may receive a first thermal runaway detection signal TRS1 that passes through the upper portions of the plurality of battery cells included in the battery pack 100 through the wiring LN22. The terminal P2_3 may receive a second thermal runaway detection signal TRS2 that passes through the upper portions of the plurality of battery cells included in the battery pack 100 through the wiring LN23. In other words, the first thermal runaway detection signal TRS1 and the second thermal runaway detection signal TRS2 may be signals that pass through the upper portions of each of the plurality of battery cells.

The BMS 200 may include a NAND gate GATE3. The NAND gate GATE3 may use the first thermal runaway detection signal TRS1 and the second thermal runaway detection signal TRS2 as inputs. The pack voltage signal PVS may be input as a power signal of the NAND gate GATE3. Accordingly, the NAND gate GATE3 may operate when the pack voltage signal PVS is the high level signal.

When the pack voltage signal PVS, the first thermal runaway detection signal TRS1, and the second thermal runaway detection signal TRS2 become the high level, the NAND gate GATE3 outputs the low level signal. When the pack voltage signal PVS and the first thermal runaway detection signal TRS1 become the high level and the second thermal runaway detection signal TRS2 becomes the low level, the NAND gate GATE3 outputs the high level signal. When the pack voltage signal PVS and the second thermal runaway detection signal TRS2 become the high level and the first thermal runaway detection signal TRS1 becomes the low level, the NAND gate GATE3 outputs the high level signal.

The BMS 200 may measure the pack voltage of the battery pack 100 through the high-level pack voltage signal PVS. However, the BMS 200 may detect the thermal runaway through the NAND gate GATE3 while maintaining standby power at low power even in a state in which a power supply is turned off.

The BMS 200 may detect whether the thermal runaway occurs in the battery pack 100 based on the output of the NAND gate GATE3. When the thermal runaway occurs in the battery pack 100, the wiring LN22 and/or the wiring LN23 may be open-circuited, and when the wiring LN22 and/or the wiring LN23 are open-circuited, the first thermal runaway detection signal TRS1 and/or the second thermal runaway detection signal TRS2 may become the low level. When at least one of the first thermal runaway detection signal TRS1 and the second thermal runaway detection signal TRS2 becomes the low level, the NAND gate GATE3 outputs the high level signal. The BMS 200 may determine that the thermal runaway occurs in the battery pack 100 based on an output signal of the high-level of the NAND gate GATE3.

The BMS 200 may diagnose that the thermal runaway occurs in the battery pack 100 when an output signal of the logic gate GATE1, GATE2, or GATE3 is the high level signal. The BMS 200 may perform a protective operation based on the output signal of the logic gate GATE1, GATE2, or GATE3. The protective operation may include a diagnostic operation, a warning operation, etc.

The diagnostic operation may be an operation to confirm whether a fire has occurred. The diagnostic operation may include an operation of calculating the temperature of the battery pack 100 based on a signal received by the BMS 200 from a temperature sensor, or determining whether gas is generated based on a signal received from a gas sensor. Here, the temperature sensor and the gas sensor may be provided in the battery system 1. The signal received from the temperature sensor may be determined according to the detected temperature, and the signal received from the gas sensor may be determined according to the type, concentration, and the like of the detected gas. When an engine of a vehicle (hereinafter, "vehicle") to which the battery system 1 is connected is turned off, the gas sensor may also be turned off. When the BMS 200 performs the diagnostic operation, the gas sensor in the turned-off state may be operated to detect a specific gas. When the BMS 200 starts the protective operation, it is possible to confirm whether a fire has occurred through the diagnostic operation.

The warning operation may include transmitting a signal notifying a higher controller of the possibility of a fire occurrence, or notifying passengers in a vehicle of the possibility of a fire occurrence through the higher controller. Here, the higher controller may be an electronic control unit (ECU), a battery system controller (BSC), etc., that control the operation of the BMS 200. The BMS 200 may provide a screen notifying passengers of the possibility of a fire occurrence through an output device installed in the vehicle, a user terminal connected to the vehicle, or the like through the higher controller. Here, the output device may be a user interface module.

An output terminal of the logic gate GATE1, GATE2, or GATE3 in FIGS. 11 to 13 may be connected to at least one component in the BMS 200. Here, each of at least one component connected to the output terminal of the logic gate GATE1, GATE2, or GATE3 may be a component to perform the protective operation by setting the high level to an on level. For example, one of at least one component connected to the output terminal of the logic gate GATE1, GATE2, or GATE3 detects the high level to operate the BMS 200 or warn passengers in a vehicle through the higher controller.

When the engine of the vehicle is turned off, the BMS 200 may not operate constantly or periodically. In one embodiment, the BMS 200 may detect the thermal runaway, etc. through the logic gate without constant or periodic operation.

According to one embodiment, the BMS 200 may detect the thermal runaway through the logic gate. Therefore, the BMS 200 may immediately perform the protective operation by detecting the output signal of the logic gate GATE1, GATE2, or GATE3 even in a low power state (e.g., when the power supply of the BMS 200 is turned off or in a standby mode). Therefore, the standby power of the BMS 200 is minimized, and the immediate thermal runaway diagnosis is possible.

In some embodiments, the BMS 200 may diagnose that the thermal runaway occurs in the battery pack 100 when the output signal of the logic gate is the low level signal.

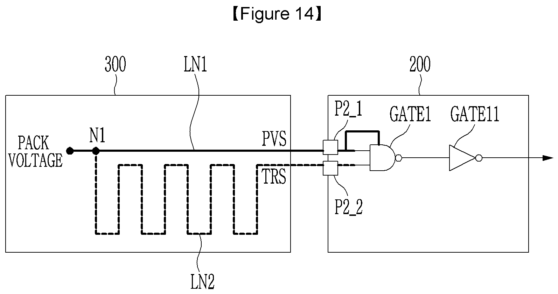

Hereinafter, referring to FIGS. 14 to 16, the configuration of the BMS 200 that may diagnose that the thermal runaway occurs in the battery pack 100 when the output signal of the logic gate is the low level signal will be described.

FIG. 14 is a diagram for describing the BMS further including the NOT gate at an output unit of the NAND gate in FIG. 11.

Referring to FIG. 14, the terminal P2_1 may receive the pack voltage signal PVS from the battery pack 100 through the first wiring LN1. The terminal P2_2 may receive the thermal runaway detection signal TRS that passes through the upper portions of each of the plurality of battery cells included in the battery pack 100 through the second wiring LN2. The BMS 200 may include the NAND gate GATE1 and a NOT gate GATE11.

The NAND gate GATE1 may use the pack voltage signal PVS and the thermal runaway detection signal TRS as inputs. The pack voltage signal PVS may also be input as the power signal of the NAND gate GATE1. Accordingly, the NAND gate GATE1 may operate when the pack voltage signal PVS is the high level signal.

The NOT gate GATE11 may use the output signal of the NAND gate GATE1 as an input. The NOT gate GATE11 may invert the output signal of the NAND gate GATE1.

When the pack voltage signal PVS and the thermal runaway detection signal TRS become the high level, the NAND gate GATE1 outputs the low level signal, and the NOT gate GATE11 outputs the high level signal. When the pack voltage signal PVS becomes the high level and the thermal runaway detection signal TRS becomes the low level, the NAND gate GATE1 outputs the high level signal, and the NOT gate GATE11 outputs the low level signal.

The BMS 200 may measure the pack voltage of the battery pack 100 through the high-level pack voltage signal PVS. However, the BMS 200 may detect the thermal runaway through the NAND gate GATE1 and NOT gate GATE11 while maintaining the standby power at the low power even in the state in which the power supply is turned off.

The BMS 200 may detect whether the thermal runaway occurs in the battery pack 100 based on the output of the NOT gate GATE11. When the thermal runaway occurs in the battery pack 100, the second wiring LN2 may be open-circuited, and when the second wiring LN2 is open-circuited, the thermal runaway detection signal TRS may become the low level. When the thermal runaway detection signal TRS becomes the low level, the NAND gate GATE1 outputs the high level signal, and the NOT gate GATE11 outputs the low level signal. The BMS 200 may determine that the thermal runaway occurs in the battery pack 100 based on an output signal of the low-level of the NOT gate GATE11.

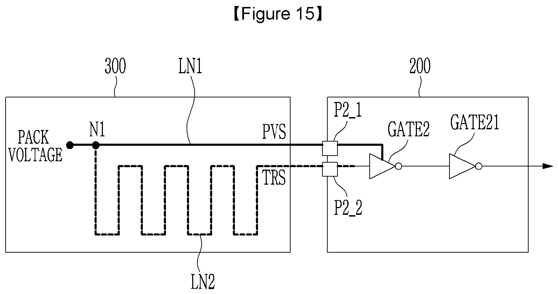

FIG. 15 is a diagram for describing the BMS further including the NOT gate at an output unit of the NOT gate in FIG. 12.

Referring to FIG. 15, the terminal P2_1 may receive the pack voltage signal PVS from the battery pack 100 through the first wiring LN1. The terminal P2_2 may receive the thermal runaway detection signal TRS that passes through the upper portions of each of the plurality of battery cells included in the battery pack 100 through the second wiring LN2. The BMS 200 may include two NOT gates GATE2 and GATE21.

The NOT gate GATE2 may use the thermal runaway detection signal TRS as an input. The pack voltage signal PVS may be input as the power signal of the NOT gate GATE2. Accordingly, the NOT gate GATE2 may operate when the pack voltage signal PVS is the high level signal.

The NOT gate GATE21 may use an output signal of the NOT gate GATE2 as an input. The NOT gate GATE21 may invert the output signal of the NOT gate GATE2.

When the pack voltage signal PVS and the thermal runaway detection signal TRS become the high level, the NOT gate GATE2 outputs the low level signal, and the NOT gate GATE21 outputs the high level signal. When the pack voltage signal PVS becomes the high level and the thermal runaway detection signal TRS becomes the low level, the NOT gate GATE2 outputs the high level signal, and the NOT gate GATE21 outputs the low level signal.

The BMS 200 may measure the pack voltage of the battery pack 100 through the high-level pack voltage signal PVS. However, the BMS 200 may detect the thermal runaway through the NOT gate GATE2 and NOT gate GATE21 while maintaining the standby power at the low power even in the state in which the power supply is turned off.

The BMS 200 may detect whether the thermal runaway occurs in the battery pack 100 based on the output of the NOT gate GATE21. When the thermal runaway occurs in the battery pack 100, the second wiring LN2 may be open-circuited, and when the second wiring LN2 is open-circuited, the thermal runaway detection signal TRS may become the low level. When the thermal runaway detection signal TRS becomes the low level, the NOT gate GATE2 outputs the high level signal, and the NOT gate GATE21 outputs the low level signal. The BMS 200 may determine that the thermal runaway occurs in the battery pack 100 based on an output signal of the low-level of the NOT gate GATE21.

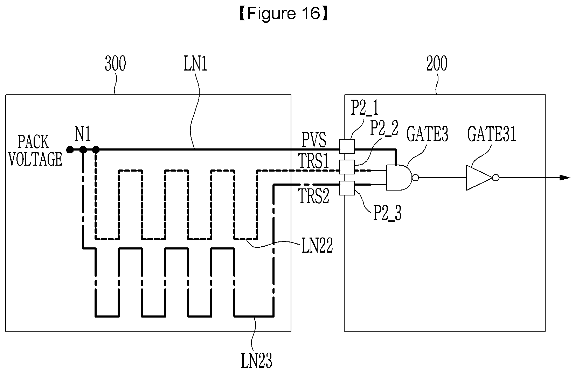

FIG. 16 is a diagram for describing the BMS further including the NOT gate at the output unit of the NAND gate in FIG. 13.

Referring to FIG. 16, the terminal P2_1 may receive the pack voltage signal PVS from the battery pack 100 through the first wiring LN1. The terminal P2_2 may receive the first thermal runaway detection signal TRS1 that passes through the upper portions of the plurality of battery cells included in the battery pack 100 through the wiring LN22. The terminal P2_3 may receive the second thermal runaway detection signal TRS2 that passes through the upper portions of the plurality of battery cells included in the battery pack 100 through the wiring LN23. In other words, the first thermal runaway detection signal TRS1 and the second thermal runaway detection signal TRS2 may be signals that pass through the upper portions of each of the plurality of battery cells.

The BMS 200 may include the NAND gate GATE3 and a NOT gate GATE31. The NAND gate GATE3 may use the first thermal runaway detection signal TRS1 and the second thermal runaway detection signal TRS2 as inputs. The pack voltage signal PVS may be input as a power signal of the NAND gate GATE3. Accordingly, the NAND gate GATE3 may operate when the pack voltage signal PVS is the high level signal.

The NOT gate GATE31 may use the output signal of the NAND gate GATE3 as an input. The NOT gate GATE31 may invert the output signal of the NAND gate GATE3.

When the pack voltage signal PVS, the thermal runaway detection signal TRS1, and the second thermal runaway detection signal TRS2 become the high level, the NAND gate GATE3 outputs the low level signal, and the NOT gate GATE31 outputs the high level signal. When the pack voltage signal PVS and the first thermal runaway detection signal TRS1 become the high level and the second thermal runaway detection signal TRS2 becomes the low level, the NAND gate GATE3 outputs the high level signal and the NOT gate GATE31 outputs the low level signal. When the pack voltage signal PVS and the second thermal runaway detection signal TRS2 become the high level and the first thermal runaway detection signal TRS1 becomes the low level, the NAND gate GATE3 outputs the high level signal and the NOT gate GATE31 outputs the low level signal.

The BMS 200 may measure the pack voltage of the battery pack 100 through the high-level pack voltage signal PVS. However, the BMS 200 may detect the thermal runaway through the NAND gate GATE3 and the NOT gate GATE31 while maintaining the standby power at the low power even in the state in which the power supply is turned off.

The BMS 200 may detect whether the thermal runaway occurs in the battery pack 100 based on the output of the NOT gate GATE31. When the thermal runaway occurs in the battery pack 100, the wiring LN22 and/or the wiring LN23 may be open-circuited, and when the wiring LN22 and/or the wiring LN23 are open-circuited, the first thermal runaway detection signal TRS1 and/or the second thermal runaway detection signal TRS2 may become the low level. When at least one of the first the thermal runaway detection signal TRS1 and the second the thermal runaway detection signal TRS2 becomes the low level, the NAND gate GATE3 outputs the high level signal, and the NOT gate GATE31 outputs the low level signal. The BMS 200 may determine that the thermal runaway occurs in the battery pack 100 based on an output signal of the low-level of the NOT gate GATE31.

Referring to FIGS. 14 to 16, the BMS 200 may diagnose that the thermal runaway occurs in the battery pack 100 when the output signal of the NOT gate GATE11, GATE21, or GATE31 becomes the low level signal. The BMS 200 may perform the protective operation based on the output signal of the logic gate GATE11, GATE21, or GATE31.

An output terminal of the logic gate GATE11, GATE21, or GATE31 in FIGS. 14 to 16 may be connected to at least one component in the BMS 200. Here, each of at least one component connected to the output terminal of the NOT gate GATE11, GATE21, or GATE31 may be a component to perform the protective operation by setting the low level to an on level. For example, one of at least one component connected to the output terminal of the NOT gate GATE11, GATE21, or GATE31 detects the low level to operate the BMS 200 or warn passengers in a vehicle through the higher controller.

According to one embodiment, the BMS 200 may detect the thermal runaway through the logic gate. Therefore, the BMS 200 may immediately perform the protective operation by detecting the output signal of the NOT gate GATE11, GATE21, or GATE31 even in the low power state. Therefore, the standby power of the BMS 200 is minimized, and the immediate thermal runaway diagnosis is possible.

Although the embodiments of the present invention have been described in detail above, the scope of the present invention is not limited thereto, and various modifications and improvements by those of ordinary skill in the field to which the present invention pertains belong to the scope of the present invention.

## Claims

1. A battery system, comprising:
battery packs including a plurality of battery cells;
a flexible printed circuit board (FPCB) located on an upper surface of the plurality of packs and including a first wiring connected to a terminal of the battery pack and a second wiring arranged along a path passing through upper portions of each of the plurality of battery cells; and
a battery management system (BMS) including a logic gate that is driven by a first voltage provided from the battery pack through the first wiring and generates an output according to a second voltage provided through the second wiring,
wherein the BMS determines whether the battery pack is abnormal according to the output of the logic gate.

2. The battery system of claim 1, wherein:when each of the plurality of battery cells is a pouch-type battery, the second wiring is arranged in a rectangular pattern passing through the upper portions of each of the plurality of battery cells.

3. The battery system of claim 1, wherein:when each of the plurality of battery cells is a cylindrical battery, a wire is connected to an upper end of the cylindrical battery, and the second wiring bypasses the wire and is arranged in a round pattern passing through the upper portions of each of the plurality of battery cells.

4. The battery system of claim 1, wherein:when each of the plurality of battery cells is a prismatic battery, the prismatic battery includes a pressure vent, and the second wiring is arranged in a rectangular pattern passing through an area corresponding to the pressure vent among the plurality of battery cells.

5. The battery system of claim 1, wherein:the logic gate is a NOT-AND (NAND) gate that uses the first voltage and the second voltage as inputs.

6. The battery system of claim 1, wherein:the logic gate is a NOT gate that uses the second voltage as an input.

7. The battery system of claim 1, wherein:the second wiring includes a third wiring and a fourth wiring arranged along the path passing through the upper portions of each of the plurality of battery cells, and
the logic gate is a NOT-AND (NAND) gate that uses a third voltage detected through the third wiring and a fourth voltage detected through the fourth wiring as inputs.

8. The battery system of any one of claim 5 to claim 7, wherein: the BMS performs a protection operation when the logic gate outputs a high level signal.

9. The battery system of any one of claim 5 to claim 7, wherein:the BMS further includes a NOT gate that uses the output of the logic gate as an input and inverts the output of the logic gate, and
the BMS performs a protection operation when the NOT gate outputs a low level signal.

10. A flexible printed circuit board electrically connecting a battery management system (BMS) and a battery pack including a plurality of battery cells, comprising:
a connector including a first terminal connected to a first input terminal of the BMS and a second terminal connected to a second input terminal of the BMS;
a first wiring connected between a positive electrode of the battery pack and the first terminal of the connector; and
a second wiring having one end connected to the first wiring at a first node and another end connected to the second terminal of the connector, and arranged along a path passing through upper portions of each of the plurality of battery cells between the one end and the other end,
wherein the BMS determines whether the battery pack is abnormal using a voltage of each of the first and second input terminals.

11. The flexible circuit board of claim 10, wherein: when each of the plurality of battery cells is a pouch-type battery, the second wiring is arranged in a rectangular pattern passing through the upper portions of each of the plurality of battery cells.

12. The flexible circuit board of claim 10, wherein: when each of the plurality of battery cells is a cylindrical battery, a wire is connected to an upper end of the cylindrical battery, and the second wiring bypasses the wire and is arranged in a round pattern passing through the upper portions of each of the plurality of battery cells.

13. The flexible circuit board of claim 10, wherein: when each of the plurality of battery cells is a prismatic battery, the prismatic battery includes a pressure vent, and the second wiring is arranged in a rectangular pattern passing through an area corresponding to the pressure vent among the plurality of battery cells.
